# NEUE EUROPÄISCHE PATENTSCHRIFT

(11) **EP 0 210 489 B2**
(45) Veröffentlichungstag und Bekanntmachung des Hinweises auf die Entscheidung über den Einspruch: **18.11.1993**
(45) Hinweis auf die Patenterteilung: 03.10.1990
(21) Anmeldenummer: 86109397.9
(22) Anmeldetag: 09.07.1986
(51) Int. Cl.: G01R 33/035, G01R 33/022

(54) **Vielkanalige Vorrichtung zur Messung schwacher Magnetfelder**
Multichannel apparatus for weak magnetic field measurement
Dispositif à plusieurs canaux pour mesurer des champs magnétiques faibles

(30) Priorität: 22.07.1985 DE 3526169
(43) Veröffentlichungstag der Anmeldung: 04.02.1987
(73) Patentinhaber: SIEMENS AKTIENGESELLSCHAFT, 80333 München (DE)
(72) Erfinder: Hoenig, Eckhardt, Dr., D-8520 Erlangen (DE)

(56) Entgegenhaltungen:
- EP-A- 0 130 490
- DE-A- 3 247 543
- US-A- 4 320 341
- JOURNAL OF APPLIED PHYSICS, Band 54, Nr. 10, Oktober 1983, Seiten 6065-6067, American Institute of Physics, New York, US; P. CARELLI et al.: "A second derivative gradiometer integrated with a dc superconducting interferometer"
- Physica 107 B (1981), Seiten 29-30
- Zusammenfassung von J: Knuutila et al: "Design considerations for multichannel SQUID magnetometers", Conference Digest, Seite 93-96, Third International Conference on Superconducting Quantum Devices, Berlin, 25-28 Juni 1985
- C.M. Pegrum et al.: "Optimising the design of thin-film D:C: SQUID gradiometers", SQUID '80, Proceedings of the Second International Conference on Superconducting Quantum Devices, Berlin, 6-9 mai 1980
- F. Wellstood et al.: "Integrated dc SQUID magnetometer with a high slew rate", Rev. Sci. Instrum. 55, Juni 1984, Seiten 952-957
- S.J. Williamson et al: "Five Channel SQUID installation for unshielded neuromagnetics instruments", Biomagnetism: Proceedings of the Fifth World Conference on Biomagnetism, Vancouver, August 1984, Seiten 46-51
- R. Ilmoniemi et al: "A four-channel SQUID magnetometer for brain research", Electroencephalography and clinical neurophysiology, 1984, Seiten 467-473
- D. Cohen: "Magnetic measurement and display of current generators in the brain"; XII International Conference on Medical and Biological Engineering, Israel, 19-24 August 1979, Seiten 15-16
- J.H. Claessen: "Coupling considerations for SQUID devices", Journal of Applied Physics; Bd. 46, Mai 1975, Seiten 2268-2275
- J: Knuutila et al.: "Design considerations for multichannel SQUID magnetometers", SQUID ?85, Seitemn 939-944

## Beschreibung

Die Erfindung bezieht sich auf vielkanalige Vorrichtungen zur Messung schwacher, sich ändernder Magnetfelder mit Feldstärken bis unter 10⁻¹⁰ T, insbesondere bis unter 10⁻¹² T, gemäß dem gattungsbildenden ersten Teil von Anspruch 1 und Anspruch 2.

Eine entsprechende Meßvorrichtung ist aus der DE-A 3 247 543 bekannt.

Die Verwendung von supraleitenden Quanteninterferometern, die auch als "SQUIDs" (Abkürzung von: "Superconducting QUantum Interference Devices") bezeichnet werden, zur Messung sehr schwacher magnetischer Felder ist allgemein bekannt ("J. Phys. E: Sci. Instrum.", Vol. 13, 1980, Seiten 801 bis 813 oder "IEEE Trans. Electr. Dev.", Vol. ED- 27, No. 10, Okt. 1980, Seiten 1896 bis 1908). Als ein bevorzugtes Anwendungsgebiet für diese Interferometer wird deshalb auch die medizinische Technik, insbesondere die Magnetokardiographie und Magnetoenzephalographie angesehen, da die von magnetischen Herz- bzw. Gehirnwellen hervorgerufenen Magneffelder Feldstärken in der Größenordnung von etwa 50 pT bzw. 0,1 pT hervorrufen ("Biomagnetism - Proceedings Third International Workshop on Biomagnetism, Berlin 1980", Berlin/New York 1981, Seiten 3 bis 31).

Die der genannten DE-A 3 247 543 zu entnehmende Vorrichtung zur Messung derartiger biomagnetischer Felder ist mehrkanalig ausgeführt, um eine räumliche Feldverteilung bei kurzen Meßzeiten und somit hinreichender Kohärenz der Felddaten bestimmen zu können. Hierzu enthält jeder Kanal ein Gradiometer erster oder höherer Ordnung, das durch supraleitende Windungen einer Sensor- oder Detektionsschleife und einer entsprechenden Kompensationsschleife ausgebildet ist. Dabei sind die Detektionsschleifen und die Kompensationsschleifen der Kanäle jeweils zu Einheiten zusammengefaßt, die räumlich voneinander getrennt sind. Die Detektionsschleife eines Gradiometers liegt also verhältnismäßig weit entfernt von der ihr zugeordneten Kompensationsschleife. Das mit diesen Schleifen im Gradiometerbereich selektiv zu erfassende noch inhomogene biomagnetische Nahfeld ("Rev. Sci. Instrum.", Vol. 53, No. 12, Dez. 1982, Seiten 1815 bis 1845) wird dann über supraleitende Verbindungsglieder in ein zugehöriges Gleichstrom-Quanteninterferometer (DC-SQUID) eingekoppelt. Derartige SQUIDs, welche zwei Josephson-Kontakte enthalten, haben gegenüber sogenannten Radiofrequenz (RF)-SQUIDs eine größere Empfindlichkeit und ein geringeres charakteristisches Rausch-Signal. Da die Gradiometer als Koppeltransformatoren ausgebildet sein können, ist auch eine induktive Einkopplung des magnetischen Flusses in die jeweiligen Interferometer mittels entsprechender Einkopplungsspulen möglich (vgl. auch "IEEE Trans. Magn.", Vol. MAG-17, No. 1, Jan. 1981, Seiten 400 bis 403).

Bei der bekannten Vorrichtung gemäß DE-A 3 247 543 sind die supraleitenden Schleifen der Gradiometer aller Kanäle auf einem gemeinsamen ebenen Trägerelement ausgebildet. Auf diesem Trägerelement ist ferner eine Trägerplatte zu befestigen, auf welcher die Interferometer aller Kanäle sowie die zugeordneten Einkopplungsspulen ausgebildet sind. Diese Einkopplungsspulen sind über im wesentlichen auf dem Trägerelement verlaufende supraleitende Verbindungsleitungen mit den Schleifen der jeweiligen Gradiometer verbunden. Somit ist eine aufwendige Kontaktierungstechnik zwischen den Einkopplungsspulen und den an sie anzuschließenden Verbindungsleitungen erforderlich.

Außerdem enthält die bekannte mehrkanalige Meßvorrichtung noch elektronische Einrichtungen zur Verarbeitung und Darstellung der an den Interferometern der Kanäle hervorgerufenen Signale, wobei normalleitende Leitungen an entsprechenden Anschlußpunkten auf der die Interferometer tragenden Platte angeschlossen sind.

Mit einem derartigen Aufbau können zwar die bei einer mehrkanaligen Ausbildung allgemein auftretenden Abgleichprobleme beherrscht werden und ist auch eine weitgehende Kohärenz der Felddaten zu gewährleisten. Jedoch ist die aktive Fläche des Systems aus Gradiometerschleifen verhältnismäßig ausgedehnt und wegen der ebenen Gestaltung des Trägerelementes im allgemeinen nicht an die Oberflächenkontur eines zu untersuchenden Probanden angepaßt. Der für die Vorrichtung erforderliche Kryostat zur Aufrechterhaltung des supraleitenden Betriebszustandes der supraleitenden Bauteile ist deshalb dementsprechend groß auszuführen.

Auch aus "Physica", Vol. 107B, 1981, Seiten 29 und 30 ist eine mehrkanalige Vorrichtung zur Messung extrem schwacher Felder zu entnehmen. Diese Meßvorrichtung enthält im Gegensatz zu der Vorrichtung gemäß der DE-A 3 247 543 mit Flußtransformatoren stattdessen sogenannte Flußführungselemente. Jedes dieser Elemente besteht im wesentlichen aus einem Nb-Rohr, das einseitig offen ist. An seiner gegenüberliegenden, geschlossenen Seite wird mittels einer besonderen Schlitzung der detektierte Fluß in SQUIDs eingekoppelt. Alle Flußführungselemente sind dabei mit den ihnen zugeordneten SQUIDs an einem scheibenförmigen Trägerelement starr befestigt. Der Aufbau der gesamten Meßvorrichtung ist dementsprechend aufwendig. Wegen der Einzelanordnung der Flußführungselemente ist außerdem deren Zahl und damit die Zahl der Meßkanäle beschränkt. Ein für die gesamte Meßvorrichtung erforderlicher Kryostat muß außerdem verhältnismäßig groß sein. Es besteht deshalb die Gefahr eines Auftretens von unerwünschten Vibrationen.

Aus der US-A-4 320 341 ist es ferner bekannt, bei einer Meßvorrichtung mit einem Gradiometer eine sogenannte "Nullung" des Gradiometerstromes, d.h. eine Kompensation dieses Stromes, vorzusehen. Hierzu wird ein Gegenkopplungssignal induktiv mittels einen Gegenkopplungstransformators in einen Flußtransformator aus Gradiometer, Einkopplungsspule und dazwischen verlaufenden Verbindungsleitern im Bereich dieser Leiter eingekoppelt.

Aufgabe der vorliegenden Erfindung ist es, die Meßvorrichtung mit den eingangs genannten Merkmalen so auszubilden, daß die aktive Fläche des Systems ihrer Gradiometer möglichst klein zu halten ist.

Eine erste Lösung dieser Aufgabe wird erfindungsgemäß in den kennzeichnenden Merkmalen des Anspruchs 1 gesehen.

Die erfindungsgemäße Meßvorrichtung läßt sich somit modular aufbauen; d.h., jeder Kanal stellt einen Modul dar, der an einer gemeinsamen, vorzugsweise den Oberflächenkonturen des zu untersuchenden Probanden angepaßten Trägerstruktur starr befestigt ist. Dabei müssen die als Dünnfilmstrukturen ausgebildeten Gradiometerschleifen jedes Moduls nur einmalig abgeglichen werden. Da sich auf jedem Modul das Interferometer zusammen mit den zugehörigen Gradiometerschleifen und den entsprechenden Verbindungsgliedern unmittelbar auf einem eigenen Trägerelement befinden, ist dabei die Verbindungstechnik zwischen diesen supraleitenden Bauteilen entsprechend vereinfacht sowie ein sehr guter Abgleich ermöglicht. Außerdem treten keine bei bekannten vielkanaligen Meßvorrichtungen zu beobachtenden Vibrationsprobleme auf. Ferner sind mit der vorgesehenen induktiven Einkopplung verhältnismäßig kleine Induktivitäten der Interferometer verbunden, so daß deren Empfindlichkeit entsprechend vergrößert ist.

Mit dieser so ausgestalteten Meßvorrichtung ist dann vorteilhaft eine parallele, d.h. gleichzeitige Registrierung insbesondere von sogenannten Isogradientenkonturen und daraus folgend die Lokalisierung der entsprechenden Feldquellen ermöglicht, wobei die Meßzeit entsprechend der Anzahl der Kanäle reduziert ist. Da mit dem erfindungsgemäßen System nur Differenzen und keine Felder gemessen werden, wird eine weitgehende Kompensation von Störfeldern erreicht.

Eine weitere Lösung der genannten Aufgabe besteht in den kennzeichnenden Merkmalen des Anspruchs 2.

Auch bei dieser erfindungsgemäßen Ausgestaltung der Meßvorrichtung ergeben sich die vorstehend aufgeführten Vorteile.

Weitere vorteilhafte Ausgestaltungen der erfindungsgemäßen Meßvorrichtungen gehen aus den abhängigen Ansprüchen hervor.

Zur weiteren Erläuterung der Erfindung wird nachfolgend auf die Zeichnung Bezug genommen, in deren Figur 1 ein Schaltungsschema einer erfindungsgemäßen Meßvorrichtung angedeutet ist. Figur 2 zeigt schematisch den Aufbau der supraleitenden Teile eines Moduls dieser Meßvorrichtung. In den Figuren 3 und 4 sind weitere Ausbildungsmöglichkeiten von Modulen für die Meßvorrichtung angedeutet.

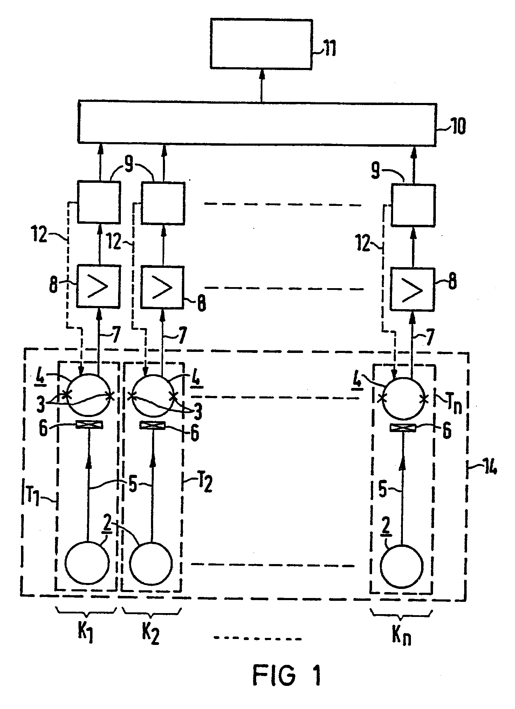

Gemäß dem in Figur 1 angedeuteten Schaltungsschema einer erfindungsgemäßen Meßvorrichtung ist eine vorbestimmte Anzahl n paralleler Meßkanäle K₁ bis Kₙ vorgesehen. Diese Vorrichtung dient vorteilhaft im Gegensatz zu bekannten vielkanaligen Vorrichtungen, mit denen Isofeldkonturen zu ermitteln sind, zur Bestimmung von Isogradientenkonturen. Jeder der beispielsweise 30 Kanäle enthält dabei ein allgemein mit 2 bezeichnetes supraleitendes Gradiometer erster Ordnung mit jeweils zwei zur Detektion und Kompensation dienenden Schleifen und ein mit zwei Josephson-Kontakten 3 ausgestattetes supraleitendes Gleichstrom-Quanteninterferometer (DC-SQUID) 4. Außerdem sind in jedem Kanal supraleitende Verbindungsglieder 5 zur Verbindung des Gradiometers mit dem Interferometer unter Einschluß einer Einkopplungsspule 6 vorgesehen, über welche die mit den Gradiometern 2 empfangenen Signale in das jeweilige Interferometer 4 induktiv eingekoppelt werden. Die so den Interferometern 4 über normalleitende Anschlußleiter 7 zu entnehmenden Signale werden dann beispielsweise über Vorverstärker 8 und sogenannte "Lock-in"-Verstärker 9 einer gemeinsamen elektronischen Datenverarbeitungs- und Steuerungseinrichtung 10 zur Weiterverarbeitung und einer Ausgabeeinheit 11 zur Darstellung zugeführt. Eine Rückkopplung in den Kanälen an die jeweiligen Interferometer mit den den Look-in-Verstärkern 9 entnommenen Signalen ist durch eine gepunktete Linie 12 angedeutet. Die Signalübertragungsrichtungen sind in der Figur durch Pfeile an den entsprechenden Linien veranschaulicht.

Wie in Figur 1 ferner durch gestrichelte Linien dargestellt ist, sollen sich in jedem Kanal die Gradiometer 2, die Interferometer 4 sowie die zugehörigen Verbindungsglieder 5 und 6 auf einem eigenen ebenen Trägerelement T₁ bis Tₙ befinden. Diese Trägerelemente sind außerdem gemeinsam auf einer durch eine gestrichelte Linie 14 angedeuteten Trägerstruktur mechanisch fest aufgebracht, wobei diese Trägerstruktur in ihrer Form vorteilhaft an die Oberflächenform eines zu untersuchenden Probanden angepaßt ist und somit insbesondere auch gewölbt sein kann.

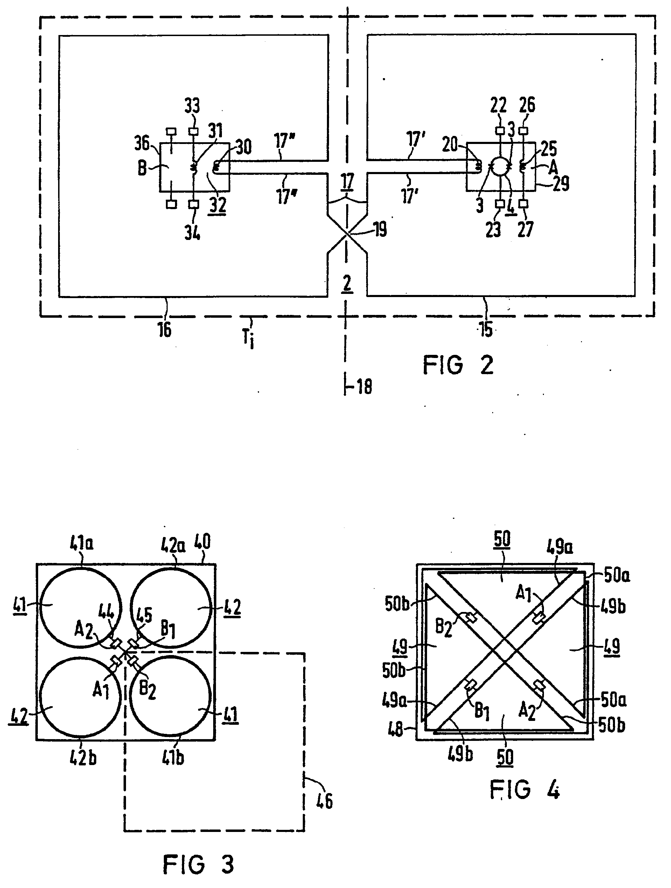

Einzelheiten der Gradiometer- und Interferometer-Anordnung eines Kanales auf einem Trägerelement gehen aus Figur 2 näher hervor. Dabei ist ein Gradiometer erster Ordnung zugrundegelegt, das bekanntlich hinsichtlich einer Abschirmung geringere Anforderungen stellt als ein Gradiometer nullter Ordnung.

Gemäß Figur 2 ist auf einem ebenen, nicht näher ausgeführten Trägerelement Tᵢ (1 ≦ i ≦ n), beispielsweise einer dünnen Quarz- oder Siliziumplatte, ein planares Gradiometer 2 erster Ordnung aufgebracht. Dieses Gradiometer wird durch eine erste Schleife 15 und eine weitere Schleife 16 sowie durch zugeordnete Verbindungsglieder 17 gebildet. Da die beiden Schleifen 15 und 16 unmittelbar benachbart sind, wirken sie kompensatorisch; d.h. mit beiden Schleifen wird sowohl eine Sensor- bzw. Detektionsfunktion als auch eine Kompensationsfunktion ausgeübt. Die jeweils eine z.B. etwa quadratische Fläche umschließenden Schleifen 15 und 16 sind dabei bezüglich einer Linie 18 symmetrisch angeordnet. Die Flächen können auch davon abweichende Formen wie z.B. die Form eines anderen Polygons oder Kreisform aufweisen. Die Windungen der Schleifen sind dabei so hintereinandergeschaltet, daß der Wickelsinn in der einen Schleife entgegengesetzt zu dem Wickelsinn in der anderen Schleife ist und im Bereich der Symmetrielinie 18 ein Überkreuzungspunkt 19 von zwischen ihnen liegenden Verbindungsleitungen ausgebildet ist. Etwa im Zentrum der von der ersten Schleife 15 eingeschlossenen Fläche ist ein Gleichstrom-Quanteninterferometer 4 ausgebildet, das zwei Josephson-Kontakte 3 aufweist. Da bei der erfindungsgemäßen Ausführungsform der magnetische Fluß des Gradiometers 2 induktiv in das Interferometer 4 eingekoppelt werden soll, sind die Leiter der Schleife 15 von der Symmetrielinie 18 her senkrecht auf das Interferometer zuführend als parallele Leiterstücke 17' ausgebildet, die an ihren dem Interferometer zugewandten Enden über eine Einkopplungsspule 20 miteinander verbunden sind. Entsprechende aus Einkopplungsspule und Gradiometerschleife gebildete Koppeltransformatoren sind allgemein bekannt (vgl. z.B. "IEEE Trans. Magn.", Vol. MAG-17, No. 1, Januar 1981, Seiten 400 bis 403). Dabei ist die Induktivität der Einkopplungsspule 20 auf die Induktivität der Gradiometerschleifen abgestimmt. Das so in dem Interferometer 4 hervorzurufende Signal wird dann über an Interferometer-Anschlußpunkten 22 und 23 anzuschließende, nicht ausgeführte elektrische Leiter aus normalleitendem Material zur Weiterverarbeitung einer Elektronik zugeleitet. Wie ferner in der Figur angedeutet ist, kann dem Interferometer 4 ferner noch eine Modulationsspule 25 mit Anschlüssen 26 und 27 für ebenfalls normalleitende, nicht dargestellte Anschlußleiter zugeordnet sein. Außerdem ist um das Interferometer sowie die ihm zugeordnete Einkopplungs- und Modulationsspule 20 bzw. 25 eine ringförmige Abschirmung 29 ausgebildet. Die von dieser Abschirmung umschlossenen Teile der erfindungsgemäßen Meßvorrichtung einschließlich der Abschirmung sind in der Figur allgemein mit A bezeichnet.

Darüber hinaus ist aus Figur 2 ersichtlich, daß eine weitgehende Spiegelsymmetrie bezüglich der Linie 18 für alle außerhalb der Abschirmung 29 liegenden supraleitenden Teile vorgesehen sein soll. Dementsprechend sind auch zwei parallele, auf das Zentrum der weiteren Schleife 16 führende Leiterstücke 17" vorgesehen, an deren zentralen Enden eine primäre Gegenkopplungswicklung 30 mit möglichst geringer Induktivät ausgebildet ist. Diese Wicklung 30 bildet zusammen mit einer sekundären Gegenkopplungswicklung 31 einen Gegenkopplungstransformator 32, mit dessen Hilfe vorteilhaft jede Änderung des Gradiometerstromes kompensiert und damit das SQUID-Signal linearisiert werden kann. Die für eine derartige "Nullung" des Gradiometerstromes erforderlichen, mit in der Figur nicht dargestellten Leitern zu verbindenden Anschlüsse an der sekundären Gegenkopplungswicklung 31 sind mit 33 bzw. 34 bezeichnet. Gegebenenfalls können darüber hinaus in dem ebenfalls von einem Abschirmring 36 umschlossenen Zentrum der weiteren Schleife 16 auch ein nicht angeschlossenes Interferometer und noch eine Modulationsspule entsprechend den Teilen 4 bzw. 25 im Zentrum der ersten Schleife 15 ausgebildet werden. Ein derartiger spiegelsymmetrischer Aufbau eines Interferometers mit integriertem Gradiometer erster Ordnung bringt fertigungstechnische Vorteile mit sich. Die Abschirmung 36 sowie die von ihr umschlossenen Teile der erfindungsgemäßen Meßvorrichtung sind in der Figur allgemein mit B bezeichnet.

Bei den in Figur 2 nicht dargestellten, in Figur 1 allgemein mit 7 bezeichneten normalleitenden Anschlußleitern kann es sich insbesondere um ein- oder doppelseitige Folienleiter, z.B. Kupfer-Streifenleitungen auf einer Kunststoff-Folie, handeln. Diese Folienleiter lassen sich dann auf den jeweiligen Trägerelementen ankleben, wobei die einzelnen Anschlußleiter mittels einer sogenannten, an sich bekannten "Bondungstechnik" mit den supraleitenden Teilen zu verbinden sind.

Gemäß den Figuren 1 und 2 wurde davon ausgegangen, daß auf einem Trägerelement jeweils nur das zu einem Kanal gehörende Gradiometer mit dem zugeordneten Interferometer sowie die entsprechenden Verbindungsglieder zwischen diesen Bauteilen anzuordnen sind. Unter Umständen kann man jedoch auch, insbesondere um eine optimale Nutzung der Fläche des Trägerelementes zu gewährleisten, zwei orthogonal wirkende Gradiometer, die zwei Kanälen zuzuordnen sind, auf einem Trägerelement vorsehen. Entsprechende Ausführungsbeispiele mit zwei Gradiometern erster Ordnung pro Trägerelement sind in den Figuren 3 und 4 schematisch als Aufsicht angedeutet.

Gemäß Figur 3 sind auf einem etwa quadratischen Trägerelement 40 zwei Gradiometer 41 und 42 mit jeweils zwei etwa kreisförmigen, in Eckbereichen diagonal gegenüberliegenden Schleifen 41a und b bzw. 42a und b angeordnet. Die beiden Gradiometer können dabei z.B. weitgehend entsprechend dem in Figur 2 dargestellten Gradiometer ausgebildet sein. Jedoch ist es auch möglich, wie in Figur 3 angedeutet sein soll, die zugehörigen Gleichstrom-Quanteninterferometer und Gegenkopplungstransformatoren mit den entsprechenden Abschirmungen in den Bereich der Verbindungslinien zwischen den jeweiligen Gradiometerschleifen zu verlegen. Diese dort anzuordnenden Teile, die in der Figur nicht näher ausgeführt sind, entsprechen also zumindest weitgehend den in Figur 2 mit A und B bezeichneten Einheiten, so daß diese Teile in Figur 3 demensprechend mit A₁ und B₁ bzw. A₂ und B₂ gekennzeichnet sind. Im Mittelpunktbereich überlappen sich dann die zu den jeweiligen Gradiometern gehörenden Verbindungsleiter 44 und 45. Wie in der Figur ferner durch eine gestrichelte Linie angedeutet sein soll, können sich gegebenenfalls benachbarte Trägerelemente 40 und 46 in Eckbereichen mit ihren dort angeordneten Gradiometerschleifen überlappen. Dies ist wegen der Nullung des Gradiometerstromes möglich. Auf diese Weise wird eine noch bessere Flächenausnutzung erreicht.

Abweichend von der Darstellung gemäß Figur 3 sind nach Figur 4 auf einem etwa quadratischen Trägerelement 48 vier zu zwei Gradiometern 49 und 50 gehörende Schleifen 49a, b bzw. 50 a, b in Form rechtwinkliger Dreiecke ausgebildet. Die Abmessungen dieser Gradiometerschleifen sind dabei so gewählt, daß diese jeweils den größten Teil einer durch eine Diagonale der Fläche des Trägerelementes 48 festgelegte Hälfte umschließen, so daß sich die Schleifen der beiden Gradiometer 49 und 50 teilweise überlappen. Dies ist wiederum wegen der erwähnten Nullung der Gradiometerströme möglich. In den verhältnismäßig schmalen diagonalen Zwischenbereichen zwischen den Gradiometerschleifen 49a und b bzw. 50a und b liegen dann die beiden zugeordneten Interferometer mit Gegenkopplungstransformatoren. Die so dort ausgebildeten Einheiten A₁ B₁ bzw. A₂, B₂ entsprechen den in Figur 3 angedeuteten Einheiten.

## Patentansprüche

1. Vielkanalige Vorrichtung zur Messung schwacher, sich ändernder Magnetfelder mit Feldstärken bis unter 10⁻¹⁰ T, insbesondere bis unter 10⁻¹² T, wobei die Vorrichtung
a) in jedem Kanal (K₁ bis Kₙ)
- ein Gradiometer (2) erster Ordnung mit einer ersten supraleitenden Gradiometerschleife (15) und einer weiteren supraleitenden Gradiometerschleife (16),
- ein dem Gradiometer (2) zugeordnetes supraleitendes (Gleichstrom-Quanteninterferometer (4) und
- supraleitende Verbindungsglieder (5, 17) zwischen dem Gradiometer (2) und dem Interferometer (4) einschließlich einer Einkopplungsspule (6, 20) zur induktiven Einkopplung der Gradiometersignale in das Interferometer (4) aufweist
sowie
b) elektronische Einrichtungen (8, 9, 10, 11) zur Verarbeitung und Darstellung der an den Interferometern (4) der Kanäle (K₁ bis Kₙ) hervorgerufenen Signale enthält,
**dadurch gekennzeichnet**, daß
α) mehrere ebene Trägerelemente (T₁ bis Tₙ) vorgesehen sind, die an einer gemeinsamen Trägerstruktur (14) befestigt sind, wobei auf jedem Trägerelement (T₁ bis Tₙ) die zu mindestens einem Kanal (K₁ bis Kₙ) gehörenden, gemäß Merkmalen a) aus
- Gradiometer (2),
- unmittelbar auf dem Trägerelement (T₁ bis Tₙ) ausgebildetem Interferometer (4) und
- Verbindungsgliedern (5, 6; 17)
gebildeten supraleitenden Bauteile angeordnet sind, und
β)
- die Interferometer (4) innerhalb der von einer Gradiometerschleife (15) ihrer zugeordneten Gradiometer umschlossenen Fläche ausgebildet sind,
- die jedem Interferometer (4) zugeordnete Einkopplungsspule (20) an die erste Gradiometerschleife (15) angeschlossen ist
und
- mit der weiteren Gradiometerschleife (16) die primäre Wicklung (30) eines Gegenkopplungstransformators (32) zur Unterdrückung eines Gradiometerstromes verbunden ist derart, daß jede Änderung des Gradiometerstromes kompensiert wird.

2. Vielkanalige Vorrichtung zur Messung schwacher, sich ändernder Magnetfelder mit Feldstärken bis unter 10⁻¹⁰ T, insbesondere bis unter 10⁻¹² T, wobei die Vorrichtung
a) in jedem Kanal (K₁ bis Kₙ)
- ein Gradiometer (2, 41, 42, 49, 50) erster Ordnung mit einer ersten supraleitenden Gradiometerschleife (15, 41a, 42b, 49a, 50b) und einer weiteren supraleitenden Gradiometerschleife (16, 41b, 42a, 49b, 50a),
- ein dem Gradiometer (2, 41, 42, 49, 50) zugeordnetes supraleitendes Gleichstrom-Quanteninterferometer (4; A₁, A₂) und
- supraleitende Verbindungsglieder (5; 44, 45) zwischen dem Gradiometer (2, 41, 42, 49, 50) und dem Interferometer (4, A₁, A₂) einschließlich einer Einkopplungsspule (6, 20) zur induktiven Einkopplung der Gradiometersignale in das Interferometer (4, A₁, A₂)
aufweist
sowie
b) elektronische Einrichtungen (8, 9, 10, 11) zur Verarbeitung und Darstellung der an den Interferometern (4, A₁, A₂) der Kanäle (K₁ bis Kₙ) hervorgerufenen Signale enthält,
**dadurch gekennzeichnet**, daß
α) mehrere ebene Trägerelemente (T₁ bis Tₙ; 40, 48) vorgesehen sind, die an einer gemeinsamen Trägerstruktur (14) befestigt sind, wobei auf jedem Trägerelement (T₁ bis Tₙ; 40, 48) als zu zwei Kanälen (K₁ bis Kₙ) gehörende supraleitende Bauteile
- zwei Gradiometer (2; 41, 42; 49, 50) mit auf dem jeweiligen Trägerelement (T₁ bis Tₙ; 40, 48) regelmäßig verteilten Gradiometerschleifen (41a,b; 42a,b; 49a,b; 50a,b),
- zumindest zwischen einzelnen benachbarten, einem Gradiometer (2; 41, 42; 49, 50) zugeordneten Gradiometerschleifen (41a,b; 42a,b; 49a,b; 50a,b) unmittelbar auf dem Trägerelement (T₁ bis Tₙ; 40; 48) ausgebildete Interferometer (4; A₁, A₂)
sowie
- die erforderlichen Verbindungsglieder (5; 44, 45) angeordnet sind
und
β)
- die jedem Interferometer (4; A₁, A₂) zugeordnete Einkopplungsspule (20) an die erste Gradiometerschleife angeschlossen ist und
- mit der weiteren Gradiometerschleife die primäre Wicklung (30) eines Gegenkopplungstransformators (32; B₁, B₂) zur Unterdrückung eines Gradiometerstromes verbunden ist derart, daß jede Änderung des Gradiometerstromes kompensiert wird.

3. Meßvorrichtung nach Anspruch 2, **dadurch ge****kennzeichnet**, daß die Schleifen (41a, b; 42a, b; 49a, b; 50a, b) der Gradiometer (41, 42; 49, 50) kreis- oder dreieckförmig gestaltet sind und in den Eckbereichen der etwa quadratisch ausgebildeten Trägerelemente (40, 48) angeordnet sind.

4. Meßvorrichtung nach einem der Ansprüche 1 bis 3, **dadurch gekennzeichnet,** daß die erste Gradiometerschleife (15) mit der Einkopplungsspule (20) und die weitere Gradiometerschleife (16) mit der primären Wicklung (30) des Gegenkopplungstransformators (32) zumindest weitgehend symmetrisch bezüglich einer Mittellinie (18) angeordnet sind.

5. Meßvorrichtung nach einem der Ansprüche 1 bis 4, **dadurch gekennzeichnet**, daß die Trägerstruktur (14) formmäßig an einen zu untersuchenden Probanden angepaßt ist.

## Claims

1. Multichannel device for measuring weak, varying magnetic fields of field strengths down to less than 10⁻¹⁰ T, in particular down to less than 10⁻¹² T, said device having
a) in each channel (K₁ to Kₙ)
- a gradiometer (2) of the first order having a first superconducting gradiometer loop (15) and a further superconducting gradiometer loop (16),
- a superconducting direct-current quantum interferometer (4) associated with the gradiometer (2), and
- superconducting connecting links (5, 17) between the gradiometer (2) and the interferometer (4), including a coupling coil (6, 20) to couple the gradiometer signals inductively to the interferometer (4),
and also containing
b) electronic apparatus (8, 9, 10, 11) to process and display the signals produced at the interferometers (4) of the channels (K₁ to Kₙ),
characterised in that
α) several planar carrier elements (T₁ to Tₙ) are provided, which elements are secured to a common carrier structure (14), there being arranged on each carrier element (T₁ to Tₙ) the superconducting components which pertain to at least one channel (K₁ to Kₙ) and which are formed according to features a) from
- gradiometer (2),
- interferometer (4) formed directly on the carrier element (T₁ to Tₙ) and
- connecting links (5, 6; 17),
and
β)
- the interferometers (4) are formed within the area enclosed by a gradiometer loop (15) of their associated gradiometers
- the coupling coil (20) associated with each interferometer (4) is connected to the first gradiometer loop (15),
and
- the primary winding (30) of a feedback transformer (32) for the suppression of a gradiometer current is connected to the further gradiometer loop (16) in such a way that any change of the gradiometer current is compensated for.

2. Multichannel device for measuring weak, varying magnetic fields of field strengths down to less than 10⁻¹⁰ T, in particular down to less than 10⁻¹² T, said device having
a) in each channel (K₁ to Kₙ)
- a gradiometer (2, 41, 42, 49, 50) of the first order having a first superconducting gradiometer loop (15, 41a, 42b, 49a, 50b) and a further superconducting gradiometer loop (16, 41b, 42a, 49b, 50a),
- a superconducting direct-current quantum interferometer (4; A₁, A₂) associated with the gradiometer (2, 41, 42, 49, 50), and
- superconducting connecting links (5: 44, 45) between the gradiometer (2, 41, 42, 49, 50) and the interferometer (4, A₁, A₂), including a coupling coil (6, 20) to couple the gradiometer signals inductively to the interferometer (4, A₁, A₂),
and also containing
b) electronic apparatus (8, 9, 10, 11) to process and display the signals produced at the interferometers (4, A₁, A₂) of the channels (K₁ to Kₙ),
characterised in that
α) several planar carrier elements (T₁ to Tₙ; 40, 48) are provided, which elements are secured to a common carrier structure (14), there being arranged on each carrier element (T₁ to Tₙ; 40, 48) as superconducting components pertaining to two channels (K₁ to Kₙ)
- two gradiometers (2; 41, 42; 49, 50) having gradiometer loops (41a,b; 42a,b; 49a,b; 50a,b), which are regularly distributed over the respective carrier element (T1 to Tₙ; 40, 48),
- interferometers (4; A₁, A₂), which are formed directly on the carrier element (T₁ to Tₙ; 40; 48) at least between individual adjacent gradiometer loops (41a,b; 42a,b; 49a,b; 50a,b) which are associated with a gradiometer (2; 41, 42; 49, 50),
and also
- the necessary connecting links (5; 44, 45), and
β)
- the coupling coil (20) associated with each interferometer (4; A₁, A₂) is connected to the first gradiometer loop, and
- the primary winding (30) of a transformer (32; B₁, B₂) for the suppression of a gradiometer current is connected to the further gradiometer loop in such a way that any change of the gradiometer current is compensated for.

3. Measuring device according to claim 2, characterised in that the loops (41a, b; 42a, b: 49a, b; 50a, b) of the gradiometers (41, 42; 49, 50) are of circular or triangular shape and are arranged in the corner areas of the substantially square carrier elements (40, 48).

4. Measuring device according to one of the claims 1 to 3, characterised in that the first gradiometer loop (15) with the coupling coil (20) and the further gradiometer loop (16) with the primary winding (30) of the feedback transformer (32) are arranged so as to be at least substantially symmetrical relative to a centre line (18).

5. Measuring device according to one of the claims 1 to 4, characterised in that the shape of the carrier structure (14) is adapted to that of a test person to be examined.

## Revendications

1. Dispositif à plusieurs canaux pour la mesure de champs magnétiques faibles et variables, avec des intensités de champs jusqu'à en-dessous de 10⁻¹⁰T, en particulier jusqu'à en-dessous de 10⁻¹²T, ce dispositif comportant
a) dans chaque canal (K₁ à Kₙ)
- un gradiomètre (2) du premier ordre ayant une première boucle supraconductrice (15) et une autre boucle supraconductrice (16),
- un interféromètre quantique supraconducteur en courant continu (4) associé au gradiomètre et
- des éléments de liaison supraconducteurs (5, 17) entre le gradiomètre (2) et l'interféromètre (4), y compris une bobine de couplage (6, 20) pour coupler inductivement les signaux du gradiomètre dans l'interféromètre,
et comprenant aussi
b) des dispositifs électroniques (8,9,10,11) pour traiter et pour représenter les signaux provoqués au niveau des interféromètres (4) des canaux (K₁, à Kₙ),
caractérisé par le fait que
α) sont prévus plusieurs éléments de support plans (T₁ à Tₙ) qui sont fixés sur une structure de support commune (14), sur chaque élément de support (T₁ à Tₙ) étant disposés des composants supraconducteurs appartenant à au moins un canal (K₁ à Kₙ) et constitués selon les caractéristiques a) par
- le gradiomètre (2)
- l'interféromètre (4) réalisé directement sur l'élément de support (T₁ à Tₙ) et - les éléments de liaison (5,6;17), et
β) les interféromètres (4) sont réalisés à l'intérieur de la surface entourée par une boucle de gradiomètres (15) de ses gradiomètres associés (2),
- la bobine de couplage (20) associée à chaque interféromètre (4) est reliée à la première boucle de gradiomètre (15), et
- l'enroulement primaire d'un transformateur à contre-réaction (32) est relié à l'autre boucle du gradiomètre (16) pour supprimer un courant de gradiomètre de façon à compenser toute variation du courant de gradiomètre.

2. Dispositif à plusieurs canaux pour la mesure de champs magnétiques faibles et variables, avec des intensités de champs jusqu'à en-dessous de 10⁻¹⁰T, en particulier jusqu'à en-dessous de 10⁻¹²T, ce dispositif comportant
a) dans chaque canal (K₁ à Kₙ)
- un gradiomètre (2,41,42,49,50) du premier ordre ayant une première boucle supraconductrice (15,41a,42b,49a, 50b) et une autre boucle supraconductrice (16,41b;42a, 49b,50a),
- un interféromètre quantique supraconducteur en courant continu (4;A₁,A₂), associé au gradiomètre (2,41,42,49, 50), et
- des éléments de liaison supraconducteurs (5; 44, 45) entre le gradiomètre (2,41,42,49,50) et l'interféromètre (4,A1,A2) y compris une bobine de couplage (6,20) pour coupler inductivement les signaux du gradiomètre dans l'interféromètre (4,A1,A2),
et comprenant aussi
b) des dispositifs électroniques (8,9,10,11) pour traiter et représenter les signaux provoqués au niveau des interféromètres (4,A1,A2) des canaux (K₁ à Kₙ),
caractérisé par le fait que
α) sont prévus plusieurs éléments de supports plans (T₁ à Tₙ; 40,48) qui sont fixés à une structure de support commune (14), sur chaque élément de support (T₁ à Tₙ; 40,48) étant disposés, en tant que composants supraconducteurs appartenant à deux canaux (K₁ à Kₙ),
- deux gradiomètres (2;41,42;49,50) avec des boucles de gradiomètres (41a,b;42a,b;49a,b;50a,b) réparties uniformément sur l'élément de support concerné (T₁ à Tₙ; 40,48),
- au moins entre les boucles de gradiomètres individuelles et voisines (41a,b; 42a,b; 49a,b; 50a,b), associées à un gradiomètre (2; 41, 42; 49, 50) un interféromètre (4; A1,A2) constitué directement sur l'élément de support (T₁ à Tₙ; 40; 48) ainsi
- que les éléments de liaison (5;44,45) qui sont nécessaires, et
β) la bobine de couplage associée à chaque interféromètre (4, A₁,A₂) est reliée à la première boucle de gradiométrie, et
- l'enroulement primaire (30) d'un transformateur à contre-réaction (32; B₁,B₂) est relié à l'autre boucle du gradiomètre pour supprimer un courant de gradiomètre, de manière à compenser toute variation du courant de gradiométre.

3. Dispositif de mesure selon la revendication 2, caractérisé par le fait que les boucles (41a,b; 42a,b; 49a,b;
50a,b) des gradiomètres (41,42;49,50) ont une conformation circulaire ou triangulaire et elles sont disposées dans les zones des sommets des éléments de support (40,48) réalisés sous la forme de carrés.

4. Dispositif de mesure selon l'une des revendications 1 à 3, caractérisé par le fait que la première boucle de gradiomètre (15) comprenant la bobine de couplage (20) et la seconde boucle de gradiomètre (16) comprenant l'enroulement primaire (30) du transformateur de contre-réaction (32) sont symétriques au moins dans une grande mesure par rapport à une ligne médiane (18).

5. Dispositif selon l'une des revendications 1 à 4, caractérisé par le fait que la structure de support (14) est adaptée, du point de vue de la forme, à un corps à examiner.
